# EUROPEAN PATENT APPLICATION

(11) **EP 4 682 222 A1**
(43) Date of publication of application: **21.01.2026**
(21) Application number: 24770853.0
(22) Date of filing: 11.03.2024
(51) Int. Cl.: C09K 5/14

(54) **THERMALLY CONDUCTIVE GREASE COMPOSITION**

(30) Priority: 13.03.2023 JP 2023039119
(71) Applicant: Cosmo Oil Lubricants Co., Ltd., Tokyo 104-8352 (JP)
(72) Inventor: TERAUCHI, Ryuji, Satte-shi, Saitama 340-0193 (JP); KIMURA, Mitsunobu, Satte-shi, Saitama 340-0193 (JP)
(74) Representative: Adamson Jones
(86) International application number: PCT/JP2024/009378
(87) International publication number: WO 2024/190747

(57) **Abstract**

A thermally conductive grease composition includes: a base oil; a thermally conductive filler containing zinc oxide and aluminum nitride; and calcium carbonate particles.

## Description

### Technical Field

The present disclosure relates to a thermally conductive grease composition.

### Background Art

Among semiconductor components used in electronic devices and the like, there are components that generate heat during use, such as a CPU of a computer and a power semiconductor for power supply control. In order to protect these semiconductor components from heat and enable them to function normally, there is a method of conducting generated heat to a heat dissipation component such as a heat sink and dissipating the heat. A thermally conductive grease composition is applied between a heat generating component such as a semiconductor component and a heat dissipation component so as to bring the components into close contact with each other, and is used for enhancing heat conduction.

As the thermally conductive grease composition, for example, Japanese Patent Application Laid-Open (JP-A) No. 2006-210437 proposes "a high thermally conductive compound containing (A) a metal powder having a thermal conductivity of 200 W/(m·K) or more and an average particle diameter of 5 to 50 µm, (B) a coarse particle inorganic filler having a new Mohs hardness of 6 or more and an average particle diameter of 5 to 50 µm, (C) a fine particle inorganic filler having an average particle diameter of 0.15 to 2 µm, (D) a base oil, and (E) one or more surface modifiers selected from a (poly)glyceryl ether, an alkenyl succinimide, and a boron derivative thereof, in which a total content of (A), (B), and (C) is in a range of from 88 to 97% by mass in the total amount of the compound, and a mass ratio of the total content of (A) and (B) to the content of (C) is in a range of from 20:80 to 85:15, and the content of (D) is less than 12% by mass in the total amount of the compound, the components (A), (B), (C), (D), and (E) are blended so that the content of the component (E) is from 0.08 to 4% by mass in the total amount of the compound.

In the thermally conductive grease composition, a thermally conductive filler selected from various thermally conductive materials is used to improve thermal conductivity. As the thermally conductive material, metal oxides such as zinc oxide and aluminum oxide, nitrides such as silicon nitride, aluminum nitride, and boron nitride, and metal powders such as aluminum, copper, and silver are used. Among such thermally conductive materials, aluminum nitride is known as a thermally conductive material having high thermal conductivity, and various improvements have been proposed (see, for example, Japanese Patent Application Laid-Open (JP-A) No. 2017-014445 and International Publication No. 2014/123247).

### SUMMARY OF INVENTION

### Technical Problem

Together with miniaturization and densification of electronic devices, there is demand for a thermally conductive grease composition having high thermal conductivity. As a means for making a thermally conductive grease composition highly thermally conductive, it is conceivable to use high filling of a thermally conductive filler or a filler having high thermal conductivity, for example.

However, high filling of a thermally conductive filler may cause an increase in viscosity of the thermally conductive grease composition and a decrease in coatability. The reduced coatability can make thin film application of the thermally conductive grease composition difficult and, in turn, deteriorate thermal resistance. Further, examples of the filler having high thermal conductivity include a metal filler and a metal nitride (e.g., aluminum nitride), but a filler having high thermal conductivity generally has poor compatibility with a resin component generally used for a thermally conductive grease composition. Therefore, the viscosity of the thermally conductive grease composition may increase owing to the inclusion of the filler having a high thermal conductivity, which may also cause deterioration in coatability.

In a thermally conductive grease composition, the thermally conductive grease composition may also shift (i.e., the pump-out phenomenon) owing to thermal shock or the like, and as a result, heat release may not be sufficiently performed. In this case, a component such as a semiconductor component that generates heat may malfunction. As a means for suppressing the occurrence of the pump-out phenomenon, for example, blending of a silicone-based polymer compound or the like is also conceivable, but the viscosity of the thermally conductive grease composition may increase, and in this case, the high filling of the thermally conductive filler may also be hindered, and the coatability of the thermally conductive grease composition may be reduced.

An object of an embodiment of the disclosure is to provide a thermally conductive grease composition that has high thermal conductivity and excellent coatability and suppresses the occurrence of the pump-out phenomenon.

### Solution to Problem

The disclosure includes the following aspects.
<1> A thermally conductive grease composition, including a base oil, a thermally conductive filler containing zinc oxide and aluminum nitride, and calcium carbonate particles.
<2> The thermally conductive grease composition according to <1>, in which a content of the calcium carbonate particles is from 0.1% by mass to 1% by mass with respect to a content of the thermally conductive filler.
<3> The thermally conductive grease composition according to <1> or <2>, in which the calcium carbonate particles have a volume average particle diameter of from 10 nm to 200 nm.
<4> The thermally conductive grease composition according to any one of <1> to <3>, in which a content of the aluminum nitride is larger than a content of the zinc oxide.
<5> The thermally conductive grease composition according to any one of <1> to <4>, in which the thermally conductive filler includes a thermally conductive filler A having a volume average particle diameter of from 0.15 µm to less than 2 µm and a thermally conductive filler B having a volume average particle diameter of from 2 µm to 40 µm, the thermally conductive filler A contains the zinc oxide, and the thermally conductive filler B contains the aluminum nitride.
<6> The thermally conductive grease composition according to <5>, in which a ratio of a content of the thermally conductive filler A to the content of the thermally conductive filler B is from 0.20 to 0.80 on a mass basis. <7> The thermally conductive grease composition according to any one of <1> to <6>, further containing a dispersant.
<8> The thermally conductive grease composition according to <7>, in which the dispersant contains a polyalkylene glycol compound having a hydroxy group.
<9> The thermally conductive grease composition according to any one of <1> to <8>, in which a total content of the thermally conductive filler is from 90% by mass to 97% by mass with respect to a total amount of the thermally conductive grease composition.
<10> The thermally conductive grease composition according to any one of <1> to <9>, in which the base oil contains a polyalphaolefin and an organic acid ester. Advantageous Effects of Invention

According to an embodiment of the disclosure, there is provided a thermally conductive grease composition that has high thermal conductivity and excellent coatability and suppresses occurrence of a pump-out phenomenon.

### DESCRIPTION OF EMBODIMENTS

Hereinafter, embodiments that are examples of the disclosure are described. These descriptions and examples illustrate embodiments and do not limit the scope of the invention.

With regard to the stepwise numerical ranges described herein, the upper limit value or the lower limit value described in one numerical range may be replaced with the upper limit value or the lower limit value of another stepwise numerical range. In the numerical range described herein, the upper limit value or the lower limit value of the numerical range may also be replaced with a value shown in Examples.

Each component may contain a plurality of corresponding substances.

When a plurality of substances corresponding to each component are present in a composition, the amount of each component in the composition, to which are referred, means the total amount of the plurality of substances present in the composition, unless otherwise specified.

In the disclosure, "% by mass" and "% by weight" are synonymous, and "parts by mass" and "parts by weight" are synonymous.

In the disclosure, a combination of two or more preferred aspects is a more preferred aspect.

In the disclosure, "JIS" is used as an abbreviation for Japanese Industrial Standards.

Unless otherwise specified, a weight average molecular weight (Mw) and a number average molecular weight (Mn) in the disclosure are molecular weights detected by a gel permeation chromatography (GPC) analyzer using a column of TSKgel SuperHM-H (trade name, manufactured by Tosoh Corporation), with a solvent PFP (pentafluorophenol)/chloroform = 1/2 (mass ratio) and a differential refractometer, and converted using polystyrene as a standard substance.

### <Thermally conductive grease composition>

The thermally conductive grease composition according to the disclosure includes a base oil, a thermally conductive filler containing zinc oxide and aluminum nitride, and calcium carbonate particles.

With the above configuration, the thermally conductive grease composition according to the disclosure has high thermal conductivity, is excellent in coatability, and suppresses the occurrence of a pump-out phenomenon. The pump-out phenomenon refers to a phenomenon in which the position of the thermally conductive grease composition disposed at a certain position shifts due to a thermal shock.

The reason why the thermally conductive grease composition according to the disclosure exerts such an effect is not clear, but the present inventors infer as follows.

Aluminum nitride is a material having excellent thermal conductivity, but when aluminum nitride is contained alone as a thermally conductive filler at a high content in the thermally conductive grease composition, the coatability of the grease composition may be significantly reduced or the composition may not be greased. In addition, even in the case of being greased, the suppression of the occurrence of the pump-out phenomenon is poor. As used herein, "greased" means that a composition containing a base oil and a thermally conductive filler is formed into a paste form exhibiting viscous deformation by an external force at normal temperature (25°C).

On the other hand, since the thermally conductive grease composition according to the disclosure includes the thermally conductive filler containing zinc oxide and aluminum nitride and the calcium carbonate particles, the thermal conductivity of the thermally conductive grease composition is improved by the interaction of the base oil, the thermally conductive filler, and the calcium carbonate particles, and an appropriate thickened state is developed. Therefore, it is presumed that favorable coatability and suppression of the occurrence of the pump-out phenomenon are exhibited.

### (Base oil)

The thermally conductive grease composition according to the disclosure contains a base oil.

The base oil is not particularly limited, and examples thereof include mineral oil, synthetic hydrocarbon oil, organic acid ester, phosphoric acid ester, silicone oil, and fluorine oil.

The base oil may be contained in the thermally conductive grease composition singly or in combination of two or more thereof.

Examples of the mineral oil include oils obtained by appropriately combining refining methods for a lubricating oil fraction of crude oil, such as solvent refining, hydrogenation refining, hydrogenolysis refining, and hydrogenation dewaxing. In addition, examples of the mineral oil include highly refined paraffinic mineral oils obtained by subjecting hydrogenated refined oils, catalytic isomerized oils, and the like to a treatment such as solvent dewaxing or hydrogenation dewaxing.

Examples of the synthetic hydrocarbon oil include a polyalphaolefin.

Examples of the polyalphaolefin include polyalphaolefins obtained by mixing and polymerizing alphaolefins produced using ethylene; propylene; butene; and a derivative thereof as a raw material singly or in combination of two or more thereof.

The polyalphaolefin is preferably a polymer of an alphaolefin having 6 to 18 carbon atoms.

The polyalphaolefin preferably contains at least one selected from the group consisting of a polymer of 1-decene and a polymer of 1-dodecene.

Examples of the organic acid ester include a monoester, a diester, and a polyol ester.

Examples of the monoester include an ester of a monobasic acid and an alcohol.

Examples of the monobasic acid include fatty acids such as butanoic acid, pentanoic acid, hexanoic acid, heptanoic acid, octanoic acid, nonanoic acid, decanoic acid, dodecanoic acid, myristic acid, pentadecylic acid, palmitic acid, margaric acid, stearic acid, eicosanoic acid, docosanoic acid, palmitoleic acid, oleic acid, and ricinoleic acid; acrylic acid; and methacrylic acid.

Examples of the alcohol used for synthesis of the monoester include oleyl alcohol, lauryl alcohol, methanol, ethanol, pentanol, hexanol, ethylene glycol, propylene glycol, glycerol, neopentyl glycol, trimethylolmethane, trimethylolethane, trimethylolpropane, trimethylolbutane, 1,2,6-hexanetriol, pentaerythritol, dipentaerythritol, and lauryl alcohol.

Examples of the diester include an ester of a dibasic acid and an alcohol.

Examples of the dibasic acid include adipic acid, azelaic acid, sebacic acid, and dodecanedioic acid.

The alcohol to be used for synthesis of the diester may be a monohydric alcohol or a polyhydric alcohol having two or more hydroxyl groups in one molecule.

As the alcohol to be used for the synthesis of the diester, the same alcohol as the alcohol to be used for the synthesis of the monoester can be applied.

Examples of the polyol ester include an ester of a polyol and a saturated fatty acid.

Examples of the polyol include a dihydric alcohol and a polyol in which no hydrogen atom is present on the carbon at the β-position based on a hydroxy group.

Examples of the dihydric alcohol include ethylene glycol, propylene glycol, butylene glycol, 2-butyl-2 ethylpropanediol, and 2,4-diethyl-pentanediol.

Specific examples of the polyol having no hydrogen atom on the carbon at the β-position based on the hydroxy group include neopentyl glycol, trimethylolpropane, and pentaerythritol.

The saturated fatty acid is not particularly limited, and examples thereof include enanthic acid, caprylic acid, pelargonic acid, capric acid, undecylic acid, lauric acid, tridecylic acid, myristic acid, pentadecylic acid, stearic acid, nonadecanoic acid, arachidic acid, and behenic acid.

Examples of the phosphoric acid ester include triethyl phosphate, tributyl phosphate, triphenyl phosphate, tricresyl phosphate, and trixylenyl phosphate.

Examples of the silicone oil include polysiloxanes such as dimethylpolysiloxane and methylphenylpolysiloxane; and modified silicone.

Examples of the fluorine oil include perfluoropolyether.

The base oil preferably contains a polyalphaolefin and an organic acid ester from the viewpoint of a favorable balance between high thermal conductivity and coatability and suppressing the occurrence of a pump-out phenomenon. In addition, application of a base oil containing a low molecular siloxane gas may cause contact failure due to the low molecular siloxane gas, but application of a polyalphaolefin and an organic acid ester is preferable from the viewpoint of preventing contact failure due to the low molecular siloxane gas.

The content of the polyalphaolefin is preferably from 70% by mass to 99% by mass, more preferably from 80% by mass to 99% by mass, and still more preferably from 85% by mass to 99% by mass, with respect to the total content of the polyalphaolefin and the organic acid ester.

The content of the base oil is preferably from 2.0% by mass to 8.5% by mass, more preferably from 3.0% by mass to 8.0% by mass, and still more preferably from 3.5% by mass to 7.0% by mass, with respect to the total amount of the thermally conductive grease composition.

From the viewpoint of high thermal conductivity, coatability, and suppression of occurrence of a pump-out phenomenon, the base oil has a kinematic viscosity at 40°C (also referred to as a 40°C kinematic viscosity) of preferably from 10 mm²/s to 600 mm²/s, and more preferably from 20 mm²/s to 450 mm²/s.

The 40°C kinematic viscosity is a value measured based on JIS K 2283:2000 kinematic viscosity test method.

### (Thermally Conductive Filler)

The thermally conductive grease composition according to the disclosure contains a thermally conductive filler. The thermally conductive filler contains zinc oxide and aluminum nitride. Since the thermally conductive filler contains zinc oxide and aluminum nitride, the thermally conductive grease composition according to the disclosure is excellent in both thermal conductivity and coatability. From the viewpoint of achieving both thermal conductivity and coatability, the content of aluminum nitride is preferably larger than the content of zinc oxide.

In the disclosure, the thermally conductive filler is a filler having a thermal conductivity of 5 W/(m·K) or more. The thermal conductivity of the thermally conductive filler is a value measured by a laser flash method (JIS R1611:2010).

The shape of the thermally conductive filler is not particularly limited. The thermally conductive filler may have any shape such as a granular shape, a crushed shape, or a spherical shape. One aspect of the thermally conductive filler is also preferably spherical.

The volume average particle diameter of the thermally conductive filler is preferably from 0.1 µm to 50 µm, more preferably from 0.15 µm to 45 µm, and still more preferably from 0.15 µm to 40 µm.

In the disclosure, the volume average particle diameter of the thermally conductive filler is measured by a laser diffraction scattering method in accordance with JIS Z 8825:2013 (corresponding international standard: ISO13320).

Specifically, in the measurement procedure, a volume distribution of the thermally conductive filler is measured for a sample containing the thermally conductive filler using a laser diffraction scattering particle size analyzer. Subsequently, the volume average particle diameter of the thermally conductive filler contained in the sample can be determined based on the obtained measured value (volume distribution).

Examples of the measuring apparatus that can be used include a laser diffraction scattering type particle size analyzer manufactured by Shimadzu Corporation under the trade name of a nanoparticle size distribution measuring apparatus SALD-7500nano.

### • Zinc oxide

The zinc oxide is not particularly limited, and examples thereof include a zinc oxide to be usually used as a thermally conductive filler. The zinc oxide may be contained in the thermally conductive filler singly or in combination with two or more thereof.

As the particle size of zinc oxide, from the viewpoint of achieving both thermal conductivity and coatability, the volume average particle diameter is preferably from 0.15 µm to 2.0 µm, more preferably from 0.2 µm to 1.5 µm, and still more preferably from 0.3 µm to 1.2 µm.

### • Aluminum nitride

The aluminum nitride is not particularly limited, and examples thereof include an aluminum nitride usually used as a thermally conductive filler. The aluminum nitride may be contained in the thermally conductive filler singly or in combination with two or more thereof.

As the particle size of the aluminum nitride, from the viewpoint of achieving both high thermal conductivity and coatability, the volume average particle diameter is preferably from 5 µm to 40 µm, more preferably from 6 µm to 30 µm, and still more preferably from 7.5 µm to 25 µm.

The thermally conductive grease composition according to the disclosure may contain a thermally conductive filler other than zinc oxide and aluminum nitride as long as the effect according to the disclosure is exhibited. The material of the other thermally conductive filler is not particularly limited, and examples thereof include magnesium oxide, aluminum oxide, titanium oxide, boron nitride, carbon, silicon carbide, and silica.

The thermally conductive filler may be a surface-treated thermally conductive filler. The surface-treated thermally conductive filler can contribute to improvement of affinity with components contained other than the thermally conductive filler.

The surface treatment of the thermally conductive filler is not particularly limited, and may be a physical treatment or a chemical treatment, and a known treatment capable of treating the surfaces of particles constituting the thermally conductive filler can be applied.

The surface treatment is preferably a treatment using a surface treatment agent.

Examples of the surface treatment agent include a silane-based coupling agent, a titanium-based coupling agent, a carboxylic acid-based coupling agent, a phosphoric acid-based coupling agent, a fatty acid, a polymer compound, a surfactant, and a fat and oil.

From the viewpoint of dispersibility, the thermally conductive filler may be surface- treated using a silane-based coupling agent as a surface treatment agent.

The total content of the thermally conductive filler is preferably from 80% by mass to 98% by mass, more preferably from 85% by mass to 97% by mass, and still more preferably from 90% by mass to 97% by mass, with respect to the total amount of the thermally conductive grease composition.

From the viewpoint of achieving both high thermal conductivity and coatability, the thermally conductive filler preferably contains two or more thermally conductive fillers having different volume average particle diameters.

One aspect of the thermally conductive filler preferably contains a thermally conductive filler A having a volume average particle diameter of from 0.15 µm to less than 2 µm and a thermally conductive filler B having a volume average particle diameter of from 2 µm to 40 µm, the thermally conductive filler A contains zinc oxide, and the thermally conductive filler B contains aluminum nitride, from the viewpoint of achieving both high thermal conductivity and coatability.

Each of the thermally conductive filler A and the thermally conductive filler B may be only one kind or may contain two or more kinds of thermally conductive fillers having different volume average particle diameters.

### -Thermally Conductive Filler A-

The thermally conductive filler A is a thermally conductive filler having a volume average particle diameter of from 0.15 µm to less than 2 µm, and contains a zinc oxide. The thermally conductive filler A may be surface-treated.

The thermally conductive filler A may contain a thermally conductive filler other than the zinc oxide, but from the viewpoint of achieving both high thermal conductivity and coatability, all of the thermally conductive fillers A are preferably the zinc oxide.

From the viewpoint of achieving both thermal conductivity and coatability, the volume average particle diameter of the thermally conductive filler A is preferably from 0.15 µm to 2.0 µm, more preferably from 0.20 µm to 1.5 µm, and still more preferably from 0.30 µm to 1.2 µm.

When two or more thermally conductive fillers A are contained, it is preferable that each of the two or more thermally conductive fillers A has a volume average particle diameter within the above range.

A procedure for measuring the volume average particle diameter of the thermally conductive filler A is as described above.

### -Thermally Conductive Filler B-

The thermally conductive filler B is a thermally conductive filler having a volume average particle diameter of from 2 µm to 40 µm and contains an aluminum nitride. The thermally conductive filler B may be surface-treated.

The thermally conductive filler B may contain a thermally conductive filler other than the aluminum nitride, but from the viewpoint of high thermal conductivity, all of the thermally conductive fillers B are preferably the aluminum nitride.

From the viewpoint of achieving both thermal conductivity and coatability, the volume average particle diameter of the thermally conductive filler B is preferably from 5 µm to 40 µm, more preferably from 6 µm to 30 µm, and still more preferably from 7.5 µm to 25 µm.

When two or more thermally conductive fillers B are contained, it is preferable that each of the two or more thermally conductive fillers B has a volume average particle diameter within the above range.

A procedure for measuring the volume average particle diameter of the thermally conductive filler B is as described above.

### -Preferred Aspects of Thermally Conductive Filler A and Thermally Conductive Filler B-

From the viewpoint of achieving both thermal conductivity and coatability, the ratio of the content of the thermally conductive filler A to the content of the thermally conductive filler B (content of thermally conductive filler A/content of thermally conductive filler B) is preferably from 0.20 to 0.80, more preferably from 0.25 to 0.7, and still more preferably from 0.30 to 0.60 on a mass basis.

The total content of the thermally conductive filler A and the thermally conductive filler B is preferably from 80% by mass to 100% by mass, more preferably from 90% by mass to 100% by mass, still more preferably from 95% by mass to 100% by mass, and particularly preferably 100% by mass, with respect to the total amount of the thermally conductive filler. That is, the thermally conductive filler contained in the thermally conductive grease composition according to the disclosure is preferably composed of the thermally conductive filler A and the thermally conductive filler B.

### (Calcium Carbonate Particles)

The thermally conductive grease composition according to the disclosure contains calcium carbonate particles.

The calcium carbonate particles refer to particles containing calcium carbonate as a main component (i.e., the content with respect to the particles is 90% by mass or more).

From the viewpoint of suppressing the occurrence of the pump-out phenomenon, a volume average particle diameter of the calcium carbonate particles is preferably from 10 nm to 200 nm, more preferably from 20 nm to 150 nm, and still more preferably from 25 nm to 100 nm.

The volume average particle diameter of the calcium carbonate particles is measured by a laser diffraction scattering method in accordance with JIS Z 8825:2013 (corresponding international standard: ISO13320).

Specifically, in the measurement procedure, a volume distribution of calcium carbonate particles is first measured for a sample containing calcium carbonate particles using a laser diffraction scattering particle size analyzer. Next, the volume average particle diameter of the calcium carbonate particles contained in the sample can be determined based on the obtained measured value (volume distribution).

Examples of the measuring apparatus that can be used include a laser diffraction scattering type particle size analyzer manufactured by Shimadzu Corporation under the trade name of a nanoparticle size distribution measuring apparatus SALD-7500nano.

The calcium carbonate particles may be surface-treated calcium carbonate particles. The surface-treated calcium carbonate particles may contribute to improvement of affinity with components contained other than the calcium carbonate particles.

The surface treatment of the calcium carbonate particles is not particularly limited, and may be a physical treatment or a chemical treatment, and a known treatment capable of treating the surfaces of calcium carbonate particles can be applied.

The surface treatment is preferably a treatment using a surface treatment agent.

Examples of the surface treatment agent include a rosin-based compound and a fatty acid.

Examples of the rosin-based compound include modified rosin and polymerized rosin.

The modified rosin refers to a modified natural rosin, and examples thereof include a hydrogenated rosin in which a double bond in a molecule is eliminated or reduced by hydrogenating a natural rosin at a high pressure using a noble metal catalyst such as a nickel catalyst, a platinum catalyst, or a palladium catalyst; and a disproportionated rosin in which unstable conjugated double bonds in the molecule are eliminated by heating a natural rosin at a high temperature in the presence of a noble metal catalyst or a halogen catalyst.

The polymerized rosin is a product obtained by reacting natural rosins or modified rosins with each other, and refers to a dimerized product, a trimerized product, or the like thereof.

The calcium carbonate particles are preferably surface-treated using a rosin-based compound as a surface treatment agent from the viewpoint of dispersibility and the viewpoint of suppressing the occurrence of the pump-out phenomenon.

From the viewpoint of suppressing the occurrence of the pump-out phenomenon, the content of the calcium carbonate particles is preferably from 0.1% by mass to 1% by mass, more preferably from 0.1% by mass to 0.8% by mass, and still more preferably from 0.1% by mass to 0.7% by mass, with respect to the content of the thermally conductive filler.

By setting the content of the calcium carbonate particles to 0.1 % by mass or more with respect to the content of the thermally conductive filler, the occurrence of the pump-out phenomenon is more easily suppressed.

By setting the content of the calcium carbonate particles to 1% by mass or less with respect to the content of the thermally conductive filler, thermal conductivity is easily improved.

### (Dispersant)

The thermally conductive grease composition according to the disclosure preferably contains a dispersant.

As the dispersant, various dispersants can be used, and a compound having a moiety expressing lipophilicity and a functional group adsorbed to the calcium carbonate particles and the thermally conductive filler is preferable.

Specific examples of the dispersant include a carboxylic acid compound and a polyalkylene glycol compound.

The carboxylic acid compound is a compound having at least one carboxy group in the molecule. Examples of the carboxylic acid compound include a fatty acid and a polycarboxylic acid (i.e., a compound having two or more carboxy groups in one molecule).

The molecular weight of the carboxylic acid compound is preferably from 100 to 2,000, more preferably from 150 to 1,500, and still more preferably from 200 to 1,000.

When the molecular weight of the carboxylic acid compound has a molecular weight distribution, the molecular weight of the carboxylic acid compound means a weight average molecular weight in terms of polystyrene measured by gel permeation chromatography (GPC). The measurement conditions and apparatus are as follows.
Measuring apparatus: Shodex GPC-101
Column: Shodex GPC LF-804 (number of columns: 3)
Detector: RI (differential refraction detector)
Temperature: 40°C
Mobile phase: THF (tetrahydrofuran)
Flow rate: 1 mL/min
Sample concentration: 1.0 mass%/vol%
Sample injection amount: 100 µL

Examples of the fatty acid as one aspect of the carboxylic acid compound include a saturated fatty acid and an unsaturated fatty acid. Examples of the saturated fatty acid include lauric acid, myristic acid, palmitic acid, stearic acid, arachidic acid, behenic acid, and lignoceric acid. Examples of the unsaturated fatty acid include caproleic acid, linderic acid, myristoleic acid, palmitoleic acid, zomarinic acid, peteroselinic acid, petroselaidic acid, oleic acid, elaidic acid, pasenoic acid, vaccenic acid, gadoleic acid, gondoic acid, cetoleic acid, erucic acid, brasic acid, ceracoleic acid, linoleic acid, linoelaidic acid, linolenic acid, and arachidonic acid. From the viewpoint of dispersibility and heat resistance, the fatty acid to be used as the dispersant is preferably erucic acid or oleic acid, more preferably erucic acid.

Another aspect of the carboxylic acid compound includes Hypermer KD-4 (weight average molecular weight: 1700), Hypermer KD-9 (weight average molecular weight: 760), Hypermer KD-12 (weight average molecular weight: 490), and Hypermer KD-16 (weight average molecular weight: 370), all manufactured by Croda Japan KK.

The polyalkylene glycol compound is a polymer compound having a repeating structure of an ether bond, and refers to, for example, a compound produced by ring-opening polymerization of a cyclic ether. The polyalkylene glycol compound is preferably a polyalkylene glycol compound having a hydroxy group.

The polyalkylene glycol compound having a hydroxy group tends to have high adhesiveness. Therefore, since the surface modifier adsorbed on the surface of the thermally conductive filler adheres to an adherend, the dispersibility of the thermoplastic filler is enhanced, and the occurrence of the pump-out phenomenon is further suppressed.

Examples of the polyalkylene glycol compound having a hydroxy group include polyalkylene glycol and an etherified product of polyalkylene glycol.

Examples of the polyalkylene glycol include polyethylene glycol, polypropylene glycol, and polybutylene glycol.

Examples of the etherified polyalkylene glycol include a compound in which polyalkylene glycol and a hydrocarbon group are bonded by an ether bond.

The number of carbon atoms of the hydrocarbon group contained in the etherified product of the polyalkylene glycol is, for example, from 12 to 65.

The structure of the hydrocarbon group is not particularly limited, and may be linear, branched, or cyclic.

Specific examples of the etherified product of the polyalkylene glycol include polyoxyethylene monooleyl ether, polyoxyethylene monostearyl ether, polyoxyethylene monocetyl ether, and polyoxyethylene lanolin alcohol, and polyoxyethylene lanolin alcohol is preferable from the viewpoint of dispersibility and favorable suppression of the occurrence of a pump-out phenomenon.

The content of the dispersant is preferably from 0.1% by mass to 1.0% by mass, more preferably from 0.1% by mass to 0.7% by mass, and still more preferably from 0.1% by mass to 0.5% by mass, with respect to the total amount of the thermally conductive grease composition.

The dispersant may be contained in the thermally conductive grease composition singly or in combination of two or more thereof. When the thermally conductive grease composition contains two or more dispersants, the above content refers to the total content of the dispersants.

### (Other Additive)

The thermally conductive grease composition according to the disclosure may contain additives other than the base oil, the thermally conductive filler, the calcium carbonate particles, and the dispersant. Examples of other additives include an antioxidant, a rust inhibitor, a corrosion inhibitor, a thickeners, a viscosity increasing agent, and detergents.

### (Physical Property Value of Thermally Conductive Grease Composition)

### -Thermal Conductivity-

The thermal conductivity of the thermally conductive grease composition according to the disclosure is preferably 4.0 W/(m·K) or more, more preferably 4.5 W/(m·K) or more, and still more preferably 5.0 W/(m·K) or more from the viewpoint of high thermal conductivity.

The thermal conductivity is measured in accordance with ISO22007-2.

As an apparatus for measuring thermal conductivity, for example, TPS2500S manufactured by Kyoto Electronics Manufacturing Co., Ltd. can be used.

### -Shear Viscosity-

From the viewpoint of coatability, the shear viscosity of the thermally conductive grease composition according to the disclosure is preferably 1000 Pa·s or less, more preferably from 50 Pa·s to 900 Pa·s, still more preferably from 100 Pa·s to 800 Pa·s, and particularly preferably from 100 Pa·s to 700 Pa·s, as measured under conditions of a measurement temperature of 25°C and a shear rate of 10 [1/s].

In the disclosure, the shear viscosity is measured using a viscoelasticity measuring apparatus under conditions of a measurement temperature of 25°C and a predetermined shear rate. As the viscoelasticity measuring device, for example, product name: MCR102e, manufactured by Anton Paar GmbH can be used.

### (Application)

The thermally conductive grease composition according to the disclosure is excellent in high thermal conductivity and coatability, and can be applied to gaps between various heat generators and heat radiators.

Examples of the heat generator include a semiconductor component, and examples of the heat radiator include a heat sink.

### <Method for Producing Thermally Conductive Grease Composition>

The method for producing the thermally conductive grease composition is not particularly limited, and a dispersant is preferably added to the base oil, the thermally conductive filler, and the calcium carbonate particles, and other additives may be, if appropriate, mixed if necessary. The order of mixing the base oil, the thermally conductive filler, the calcium carbonate particles, the dispersant, and other additives is not particularly limited, and each component may be sequentially mixed with the base oil.

### Examples

Examples are described below, but the thermally conductive grease composition according to the disclosure is not limited to these examples at all.

### <Examples 1 to 4 and Comparative Examples 1 to 6>

A base oil, a thermally conductive filler, a dispersant, and other additives (an antioxidant and a pump-out inhibitor) were mixed at blending proportions (% by mass) shown in the following Table 1.

Blanks in the composition column shown in Table 1 indicate that the corresponding components are not blended.

In Examples 1 to 4, a thermally conductive grease composition having the composition shown in Table 1 was prepared. Comparative Examples 2 and 3 was not greased. Therefore, the following performance evaluation was not performed for Comparative Examples 2 and 3.

### <Evaluation>

The following performance evaluation was performed using each of the thermally conductive grease compositions of Examples obtained as described above and the thermally conductive grease compositions of Comparative Examples 1 and 4 to 6.

### (Thermal Conductivity)

The thermal conductivity was measured in accordance with ISO 22007-2.

As a thermal conductivity measuring apparatus, TPS2500S manufactured by Kyoto Electronics Manufacturing Co., Ltd. was used. The thermal conductivity of 4.0 W/(m·K) or more means that the thermally conductive grease composition has high thermal conductivity.

### (Evaluation of Coatability)

The coatability was evaluated by the shear viscosity measured under the conditions of a measurement temperature of 25°C and a shear rate of 10 [1/s] using a viscoelasticity measuring device (Product name: MCR102e, manufactured by Anton Paar GmbH).

When the shear viscosity measured under the condition of 10 [1/s] is 1000 Pa·s or less, it means that the thermally conductive grease composition is excellent in coatability, and when the shear viscosity is 700 Pa·s or less, it means that the thermally conductive grease composition is particularly excellent in coatability.

### (Evaluation of Pump-Out Property)

In the evaluation of the pump-out property, two evaluations of Evaluation A and Evaluation B were performed.

A spacer was installed between an aluminum plate (product name: A5052P, 80 mm in length × 60 mm in width × 1 mm in thickness) and a slide glass (76 mm in length × 26 mm in width × 1.2 mm to 1.5 mm in thickness), and a given amount of grease was applied and sandwiched therebetween to obtain a test piece. The thickness of the spacer was 0.2 mm in Evaluation A and 1.0 mm in Evaluation B.

During preparation of the test piece, the amount of grease was set to be a circle having a diameter of 15 mm when sandwiched between the aluminum plate and the slide glass. In addition, the aluminum plate and the slide glass were installed such that longitudinal directions thereof were aligned in the same direction.

In each of Evaluation A and Evaluation B, a thermal shock test was performed by repeatedly changing the temperature between -40°C and 85°C with the longitudinal direction of the test piece set as a vertical direction. The thermal shock test was performed for a total of 500 cycles in which an operation of cooling under -40°C conditions for 30 minutes, then transferring to an environment of 85°C, and heating under 85°C conditions for 30 minutes was defined as 1 cycle. A thermal shock testing machine TSE-11-A manufactured by ESPEC CORPORATION was used.

After 500 cycles, the moving distance (mm) of the grease from the original position was measured to evaluate the pump-out property.

Based on the measured moving distance, the pump-out property was evaluated according to the following evaluation criteria. The smaller the moving distance, the more the occurrence of the pump-out phenomenon is suppressed.

### -Evaluation Criteria-

A: The moving distance is less than 5 mm.
B: The moving distance is 5 mm or more and less than 10 mm.
C: The moving distance is 10 mm or more and less than 20 mm.
D: The moving distance is 20 mm or more.

The above results are shown in Table 1.

**[Table 1]**

| | | | Example | | | | Comparative Example | | | | | |
|---|---|---|---|---|---|---|---|---|---|---|---|---|
| | | | 1 | 2 | 3 | 4 | 1 | 2 | 3 | 4 | 5 | 6 |
| Base oil | Polyalphaolefin 1 | | 3.68 | 3.68 | 1.46 | 1.71 | 4.23 | 4.23 | 4.23 | 4.23 | 4.61 | 5.38 |
| | Polyalphaolefin 2 | | | | 1.46 | 1.71 | | | | | | |
| | Polyalphaolefin 3 | | 0.55 | 0.55 | 1.50 | 1.00 | 0.63 | 0.63 | 0.63 | 0.63 | 0.69 | 0.80 |
| | Lauryl methacrylate | | 0.15 | 0.15 | 0.40 | 0.40 | 0.17 | 0.17 | 0.17 | 0.17 | 0.19 | 0.22 |
| Dispersant | Dispersant 1 | | 0.15 | 0.15 | 0.20 | 0.20 | 0.15 | 0.15 | 0.15 | 0.15 | 0.16 | 0.19 |
| | Dispersant 2 | | 0.15 | 0.15 | | | 0.15 | 0.15 | 0.15 | 0.15 | 0.16 | 0.19 |
| | Dispersant 3 | | 0.12 | 0.12 | 0.14 | 0.14 | | | | | | |
| Other Additives | Antioxidant | | 0.10 | 0.10 | 0.15 | 0.15 | 0.17 | 0.17 | 0.17 | 0.17 | 0.19 | 0.22 |
| Calcium carbonate particle | Calcium carbonate particle 1 (30 nm) (rosin-based treatment) | | 0.60 | 0.60 | 0.19 | 0.19 | | | | | | |
| Thermally conductive filler | Zinc oxide 1 (0.6 µm) | | 33.9 | 33.9 | 33.9 | 33.9 | 33.9 | | 33.9 | 33.9 | 33.7 | 33.4 |
| | Aluminum nitride 1 (7.0 µm) | | | | | | | 33.9 | | | | |
| | Aluminum nitride 2 (5.52 µm) | | | | | | | | 60.6 | | | |
| | Aluminum nitride 3 (38.31 µm) | | | | | | | | | 60.6 | 60.3 | 59.6 |
| | Aluminum nitride 4 (17.8 µm) | | 60.6 | | 60.6 | 60.6 | 60.6 | 60.6 | | | | |
| | Aluminum nitride 5 (17.8 µm) | | | 60.6 | | | | | | | | |
| Total | | [% by mass] | 100.00 | 100.00 | 100.00 | 100.00 | 100.00 | 100.00 | 100.00 | 100.00 | 100.00 | 100.00 |
| Filling rate | | [% by mass] | 94.5 | 94.5 | 94.5 | 94.5 | 94.5 | 94.5 | 94.5 | 94.5 | 94 | 93 |
| | | [Vol%] | 80.1 | 80.1 | 79.5 | 79.4 | 78.8 | 81.2 | 78.5 | 78.5 | 76.9 | 73.8 |
| Filler A/Filler B [mass ratio] | | | 0.56 | 0.56 | 0.56 | 0.56 | 0.56 | - | 0.28 | 0.56 | 0.56 | 0.56 |
| Density [g/cm³] | | | 3.28 | 3.28 | 3.26 | 3.25 | 3.23 | 2.87 | 3.29 | 3.29 | 3.24 | 3.14 |
| Evaluation result | Thermal conductivity [W/(m·k)] | | 6.0 | 6.1 | 5.9 | 6.0 | 6.1 | Not greased | Not greased | 5.9 | 5.8 | 6.0 |
| | Shear viscosity [Pa·s] (coating property) | 10 [l/s] | 302 | 421 | 720 | 537 | 157 | | | 70 | 121 | 221 |
| | Evaluation of pump-out property | A (thickness: 0.2 mm) | B | B | A | A | D | | | D | D | D |
| | | B (thickness: 1.0 mm) | C | C | A | A | D | | | D | D | D |

In Table 1, filler A and filler B correspond to thermally conductive filler A and thermally conductive filler B, respectively.

Details of the components in Table 1 are described below.

### (Base Oil)

### -Polyalphaolefin-

- Polyalphaolefin 1: product name: DURASYN-168, manufactured by INEOS Oligomers, polyalphaolefin (polymer of 1-decene), kinematic viscosity at 40°C: 46.4 mm²/s
- Polyalphaolefin 2: product name: DURASYIN-170, manufactured by INEOS Oligomers, polyalphaolefin (polymer of 1-decene), kinematic viscosity at 40°C: 65.3 mm²/s
- Polyalphaolefin 3: product name: DURASYN-180R, manufactured by INEOS Oligomers, kinematic viscosity at 40°C: 935 mm²/s

### -Organic Acid Ester-

- Lauryl methacrylate: product name: Light Ester L, manufactured by Kyoeisha Chemical Co., Ltd., lauryl methacrylate

### (Thermally Conductive Filler)

### -Zinc Oxide-

- Zinc oxide 1: product name: Zinc Oxide No1, manufactured by SAKAI CHEMICAL INDUSTRY CO., LTD., zinc oxide particles, volume average particle diameter: 0.6 µm

### -Aluminum Nitride-

- Aluminum nitride 1: product name: AN-HF07LG-HTZ, manufactured by MARUWA Co., Ltd., aluminum nitride (AlN) particles, volume average particle diameter: 7.0 µm
- Aluminum nitride 2: product name: ANF-A-05-F-WR2, manufactured by MARUWA Co., Ltd., aluminum nitride (AlN) particles, phosphate treatment, volume average particle diameter: 5.52 µm
- Aluminum nitride 3: product name: ANF-S-30-WR2, manufactured by MARUWA Co., Ltd., aluminum nitride (AlN) particles, phosphate treatment, volume average particle diameter: 38.31 µm
- Aluminum nitride 4: product name: HF-20h, manufactured by Tokuyama Corporation, aluminum nitride (AlN) particles, volume average particle diameter: 17.8 µm
- Aluminum nitride 5: product name: HF-20, manufactured by Tokuyama Corporation, aluminum nitride (AlN) particles, volume average particle diameter: 17.8 µm

### (Calcium Carbonate Particles)

- Calcium carbonate particles 1: product name: HAKUENKA O, manufactured by Shiraishi Kogyo Kaisha, Ltd., calcium carbonate particles surface-treated with rosin-based compound, volume average particle diameter: 30 nm

### (Dispersant)

- Dispersant 1: product name: Hypermer KD-9, manufactured by Croda Japan KK, carboxylic acid compound, polycarboxylic acid, weight average molecular weight: 760
- Dispersant 2: product name: erucic acid, manufactured by NOF CORPORATION, carboxylic acid compound, erucic acid
- Dispersant 3: product name: Polycol 15, manufactured by Croda Japan KK, polyoxyethylene lanolin alcohol

### (Other Additive)

- Antioxidant: manufactured by BASF Japan Ltd., Irganox L57, reaction product of N-phenylbenzenamine and 2,4,4-trimethylpentene

From the above results, it is found that the thermally conductive grease compositions of the present examples have high thermal conductivity, are excellent in coatability, and suppress the occurrence of the pump-out phenomenon.

The disclosure of Japanese Patent Application No. 2023-039119 filed on March 13, 2023 is incorporated herein by reference in its entirety.

All documents, patent applications, and technical standards described in this specification are incorporated herein by reference to the same extent as if each individual document, patent application, or technical standard was specifically and individually indicated to be incorporated by reference.

## Claims

1. A thermally conductive grease composition, comprising:
a base oil;
a thermally conductive filler containing zinc oxide and aluminum nitride; and
calcium carbonate particles.

2. The thermally conductive grease composition according to claim 1, wherein a content of the calcium carbonate particles is from 0.1% by mass to 1% by mass with respect to a content of the thermally conductive filler.

3. The thermally conductive grease composition according to claim 1 or 2, wherein the calcium carbonate particles have a volume average particle diameter of from 10 nm to 200 nm.

4. The thermally conductive grease composition according to claim 1 or 2, wherein a content of the aluminum nitride is greater than a content of the zinc oxide.

5. The thermally conductive grease composition according to claim 1 or 2, wherein:
the thermally conductive filler comprises a thermally conductive filler A having a volume average particle diameter of from 0.15 µm to less than 2 µm and a thermally conductive filler B having a volume average particle diameter of from 2 µm to 40 µm,
the thermally conductive filler A comprises the zinc oxide, and
the thermally conductive filler B comprises the aluminum nitride.

6. The thermally conductive grease composition according to claim 5, wherein a ratio of a content of the thermally conductive filler A to a content of the thermally conductive filler B is from 0.20 to 0.80 on a mass basis.

7. The thermally conductive grease composition according to claim 1 or 2, further comprising a dispersant.

8. The thermally conductive grease composition according to claim 7, wherein the dispersant comprises a polyalkylene glycol compound having a hydroxy group.

9. The thermally conductive grease composition according to claim 1 or 2, wherein a total content of the thermally conductive filler is from 90% by mass to 98% by mass with respect to a total amount of the thermally conductive grease composition.

10. The thermally conductive grease composition according to claim 1 or 2, wherein the base oil comprises a polyalphaolefin and an organic acid ester.
